# EUROPEAN PATENT APPLICATION

(11) **EP 3 327 334 A1**
(43) Date of publication of application: **30.05.2018**
(21) Application number: 16382561.5
(22) Date of filing: 24.11.2016
(51) Int. Cl.: F21S 8/10, H01L 23/498, H01L 21/48, H01L 23/538, H01L 33/62, H01L 33/64, H05K 1/02, H05K 1/11, F21V 29/00, F21V 19/00

(54) **AUTOMOTIVE ELECTRONIC ASSEMBLY AND METHOD**

(71) Applicant: VALEO ILUMINACION, 23600 Martos (ES)
(72) Inventor: TEBA, Daniel, 23600 Martos (ES); GUZMAN, Alfonso-Manuel, 23560 Huelma (ES); MARTINEZ, Francisco, 18500 Guadix (Granada) (ES)

(57) **Abstract**

The invention provides a electronic assembly (1) comprising a light source (21, 22), a heat sink (3) in thermal contact with the light source (21, 22), a plastics substrate (4) at least partially coating the heat sink (3) and a conductive track (5) directly deposited on the plastics substrate (4). The conductive track (5) is electrically connected to the light source (21, 22). The invention also provides a manufacturing method for this electronic assembly (1).

## Description

### TECHNICAL FIELD

The present invention belongs to the field of electronic assemblies comprising conductive tracks directly deposited on a plastics substrate.

### STATE OF THE ART

Automotive lighting devices require the arrangement of electric circuits to feed light sources. As every arrangement related to the automotive industry, space and cost need to be minimized, which is not normally the case when conventional printed circuit boards (PCB) are provided. PCBs are often expensive to manufacture and they require a dedicated space within the automotive lighting device.

### DESCRIPTION OF THE INVENTION

The invention provides a solution for this problem by means of an automotive electronic assembly according to claim 1 and a method for manufacturing an automotive electronic assembly according to claim 12. Preferred embodiments of the invention are defined in dependent claims.

In an inventive aspect, the invention provides an automotive electronic assembly comprising
a light source;
a heat sink in thermal contact with the light source;
a plastics substrate at least partially coating the heat sink;
a conductive track directly deposited on the plastics substrate, the conductive track being electrically connected to the light source.

Direct deposition of a conductive track on a plastics substrate should be construed as forming the final shape of the conductive track on the plastics substrate without the need of removing metal or for any other intermediate element, such as a mask, an electrolyte or any other chemical bath or a photosensitive film. The conductive track is just directly placed on the plastics substrate.

The thermal contact between the light source and the heat sink should be understood in the sense that the electronic assembly enables heat transfer between the light source and the heat sink, either by direct contact or by means of an intermediate element. This thermal contact may be embodied in some different ways. In some embodiments, the electronic assembly would comprise a plastics substrate with a conductive track directly deposited on it and the light source being placed in direct contact with the heat sink but electrically connected to the conductive track.

Directly depositing a conductive track on a plastics substrate supposes substantial cost savings, due to the fact that a dedicated printed circuit board need not be provided. Therefore, other integral parts of the device to be controlled with the electronic assembly can be taken advantage of to play the role of substrate for the conductive track, leading to a more compact electronic assembly.

Furthermore, the process of direct deposition of the conductive track usually implies shorter manufacturing times and conductive material savings -in contrast to most PCB manufacturing methods, there is no need for removing regions of conductive material or for using an additional product, such as an electrolyte, to define the conductive track.

In particular embodiments, the plastics substrate is a three-dimensional plastics substrate.

A three-dimensional plastics substrate should be construed as a plastics substrate whose surface on which the conductive track extends is not completely contained in a plane. Direct deposition is particularly appropriate for such three-dimensional surfaces, in comparison to other known techniques which normally require planar surfaces for printing a circuit board.

Advantageously, this automotive electronic assembly does not need a "flexboard" to provide electric connection between light sources being located on different sides of the heat sink. "Flexboards" are usually used to ensure electric continuity along a three-dimensional circuit. However, they normally are an expensive part.

In some particular embodiments, the three-dimensional plastics substrate is arranged in such a way that a first region of the three-dimensional plastics substrate extends on a first face of the heat sink and a second region of the three-dimensional plastics substrate extends on a second face of the heat sink opposite to the first face.

This arrangement enables the use of this electronic assembly for providing at least two different light patterns, such as a high-beam and a low-beam pattern or an anti-fog beam.

In a particular embodiment, the plastics substrate is made of at least one of the following materials: acrylonitrile butadiene styrene (ABS), polycarbonate, blends of both materials (ABS + PC), polybutylene terephthalate or polyamide.

These materials provide good properties when being combined with the heat sink and with the conductive track, thus achieving a good attachment between them.

In some particular embodiments, the conductive track is deposited by plasma deposition. This step may be carried out, for instance, using the device described in document US 2015/174686 A1, and concretely in its claim 1. These conductive tracks suit perfectly for this automotive electronic assembly, as they are deposited directly over the plastics substrate, without the need for any flexboard to provide electric connection between two different faces of the heat sink.

In some particular embodiments, the light source is a semiconductor light source. These light sources are very efficient and are adapted to optimally perform in many lighting applications.

In a particular embodiment, the heat sink is made of aluminium. This material is advantageously used because of its lightness, low price, ease of manufacturing and heat dissipation properties.

In some particular embodiments, the electric connection between the light source and the conductive track is made by means of at least one conductive wire which is attached both to one of the semiconductor light sources and to the conductive track.

In a particular embodiment, the automotive electronic assembly comprises a plurality of light sources, at least an upper light source being located on the first region and at least a lower light source being located on the second region.

This embodiment is also useful for its use in an automotive headlamp that requires two different light sources with different properties and features in order to provide a high-beam and a low-beam pattern. The heat sink is at the same time the heat dissipation element and the separation element between the two semiconductor light sources. This configuration is very simple and easy to install in an automotive vehicle.

In some embodiments, the automotive electronic assembly further comprises
an upper reflector arranged to reflect the light emitted by the upper semiconductor light source; and
a lower reflector arranged to reflect the light emitted by the lower semiconductor light source.

In a particular embodiment, the automotive electronic assembly further comprises a folder configured to block at least part of the light reflected by the upper reflector in order to form a low-beam light pattern.

The folder comprises a forward edge whose shape is designed so as to give rise to a cut-off line in the low beam light pattern.

In another inventive aspect, the invention provides an automotive lighting device comprising
an automotive electronic assembly according to the previous inventive aspect;
an optical element suitable for receiving light emitted by the light source and for shaping the light into a light pattern projected outside the lighting device; and
a housing accommodating the automotive electronic assembly and the optical element.

An optical element is an element that has some optical properties to receive a light beam and emit it in a certain direction and/or shape, as a person skilled in automotive lighting would construe without any additional burden. Reflectors, collimators, light guides, projection lenses, etc., or the combination thereof are some examples of these optical elements.

Lighting devices for automotive vehicles can benefit from the use of electronic assemblies comprising conductive tracks directly deposited on a plastics substrate. In the first place, a wide range of the lighting device's parts can be used either as plastics substrate or as base for the plastics substrate (in which case the plastics substrate may for instance coat the base), taking into account that even three-dimensional plastics substrates are suitable for direct deposition of conductive tracks. Therefore, a dedicated printed board circuit is not required, which leads to reducing the cost and the weight of the lighting device. As was stated above, cost savings are even more significant due to the fact that direct deposition does not normally want removing conductive material to shape the conductive tracks.

In another inventive aspect, the invention provides a method for manufacturing an automotive electronic assembly according to the previous inventive aspect, the method comprising the steps of
providing a light source;
providing a heat sink in thermal contact with the light source;
coating the heat sink with a three-dimensional plastics substrate;
depositing a conductive track directly on the plastics substrate; and
provide an electric connection between the light source and the conductive track.

This manufacturing method makes the use of a flexboard unnecessary. It achieves the production of a versatile automotive electronic assembly in a very inexpensive and compact way.

In some particular embodiments, the step of depositing a conductive track directly on the plastics substrate is carried out by plasma deposition.

This way of depositing conductive tracks is very adequate for this particular manufacturing method, as allows the tracks to be directly laid on the plastics substrate, in a three-dimensional way, so they can adapt to the geometry of the plastics substrate, thus making the product of this method suitable for many different applications, including the automotive industry.

In some particular embodiments, the step of coating the heat sink with a three-dimensional plastics substrate is carried out in such a way that a first region of the three-dimensional plastics substrate is extended on a first face of the heat sink and a second region of the three-dimensional plastics substrate is extended on a second face of the heat sink opposite to the first face.

The step of coating two opposite faces of the heat sink with the plastics substrate allows the use of this automotive electronic assembly where two lighting sources arrangement are required.

In some particular embodiments, the step of coating the heat sink with a three-dimensional plastics substrate is carried out by overmoulding the plastics substrate directly over the heat sink.

This way of placing the plastics substrate on the automotive electronic assembly avoids unnecessary intermediate parts, thus saving weight and space.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figures 1a and 1b show a particular embodiment of an automotive electronic assembly according to the invention.
Figure 2a to 2c show some steps of a manufacturing method according to the invention.
Figure 3 shows a lighting device according to the invention in an automotive vehicle.

### DETAILED DESCRIPTION OF THE INVENTION

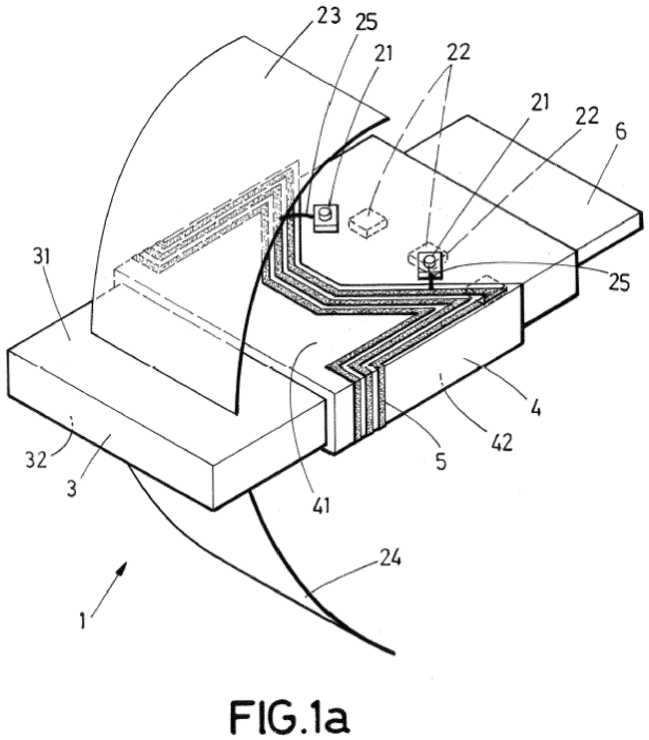

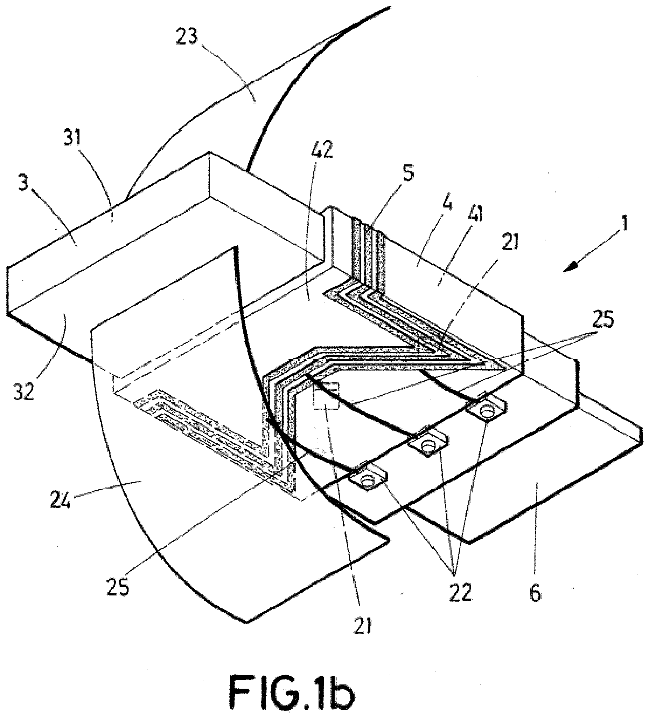

Figures 1 a and 1b show two different views of a particular embodiment of an automotive electronic assembly 1 according to the invention. This automotive lighting device 1 comprises
an upper semiconductor light source 21;
a lower beam semiconductor light source 22;
an upper reflector 23 arranged to receive the light emitted by the upper semiconductor light source 21 and reflect it; and
a lower reflector 24 arranged to receive the light emitted by the lower semiconductor light source 22 and reflect it.
a heat sink 3 in thermal contact with the semiconductor light sources 21, 22;
a three-dimensional plastics substrate 4 at least partially coating the heat sink 3;
a conductive track 5 directly deposited on the plastics substrate 4 by plasma deposition, the conductive track 5 being electrically connected to the upper and lower semiconductor light sources 21, 22.

The heat sink comprises a first face 31 and a second face 32, which is opposite to the first face 31. The three-dimensional plastics substrate 4 comprises a first region 41 which extends on the first face 31 of the heat sink 3 and a second region 42 which extends on the second face 32 of the heat sink 3 opposite to the first face 31.

In the particular embodiment shown in this figure, the automotive electronic assembly 1 comprises two upper light sources 21 on the first face 31 of the heat sink 3 and three lower light sources 22 on the second face of the heat sink 3. All of these light sources 21, 22 are electrically connected to the conductive track 5 directly located on the plastics substrate 4. In different embodiments, the upper light sources 21 are located on the first region 41 of the plastics substrate 4 and the lower light sources 22 are located on the second region 42 of the plastics substrate 4.

The upper semiconductor light sources 21 are located in thermal contact with the first face 31 of the heat sink 3, and are electrically connected to the piece of the conductive track 5 deposited on the piece of the three-dimensional plastics substrate 4 which coats the first face 31 of the heat sink 3. The lower semiconductor light sources 22 are located in thermal contact with the second face 32 of the heat sink 3, and are electrically connected to the piece of the conductive track 5 deposited on the piece of the three-dimensional plastics substrate 4 which coats the second face 32 of the heat sink 3.

The electric connection between the upper and lower semiconductor light sources 21, 22 and the conductive track 5 is made by means of conductive metal wires or ribbons 25, each of which is attached both to one of the semiconductor light sources 21, 22 and to the conductive track 5.

The automotive electronic assembly 1 further comprises a folder 6, which in some embodiments is a separate part.

The operation of this automotive electronic assembly comprises the emission of light by the LED devices of the upper and lower semiconductor light sources 21, 22. This light is received by the upper and lower reflectors 23, 24 and then is reflected in a forward direction. Part of the light reflected by the upper reflector 23 is blocked by the folder 6, which ensures that a low beam light pattern comprises a cut-off line required by the regulations.

The three-dimensional plastics substrate 4 is made of at least one of the following materials: acrylonitrile butadiene styrene ABS, polycarbonate, a blend of both (ABS + PC), polybutylene terephthalate or polyamide. The heat sink 3 is in turn made of aluminium, an aluminium alloy or a thermal conductive plastic.

The invention also provides a manufacturing method for this automotive electronic assembly. This method comprises the steps of
a. providing a light source 21, 22;
b. providing a heat sink 3 in thermal contact with the light source 21, 22;
c. coating at least a first face 31 of the heat sink 3 and a second face 32 of the heat sink 3 opposite to the first face 31 with a three-dimensional plastics substrate 4, by overmoulding the plastics substrate 4 directly over the heat sink 3;
d. depositing a conductive track 5 directly on the plastics substrate 4 by means of plasma deposition; and
e. provide an electric connection between the light source 21, 22 and the conductive track 5.

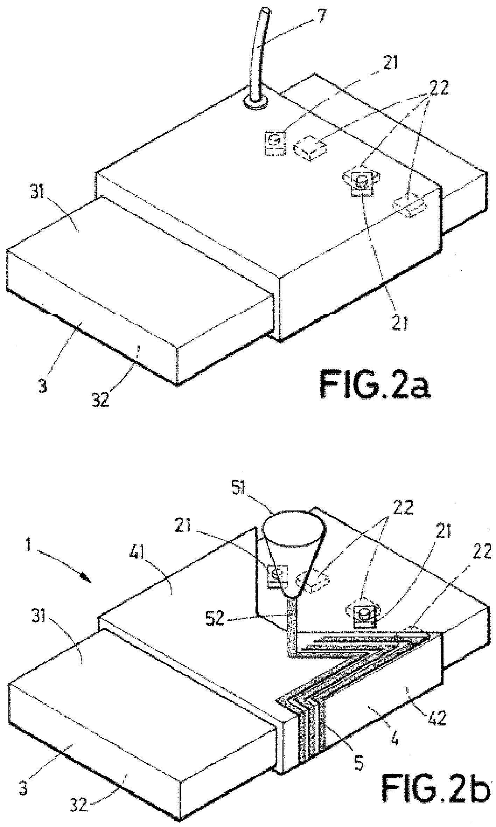

Figure 2a shows the steps a, b and c of a method according to the invention. A three-dimensional plastics substrate is overmoulded directly over the heat sink by means of an injection nozzle 7, thus coating the first face 31 and the second face 32 of the heat sink 3. In some particular embodiments, this overmoulding step is carried out in a plastic injection machine, where the heat sink and the light sources 21, 22 are introduced.

Figure 2b shows the step d of a method according to the invention. A plasma nozzle 51 projects a plasma flow 52 with metal dust particles. These particles solidify in contact with the plastics substrate 4, thus creating a conductive track 5.

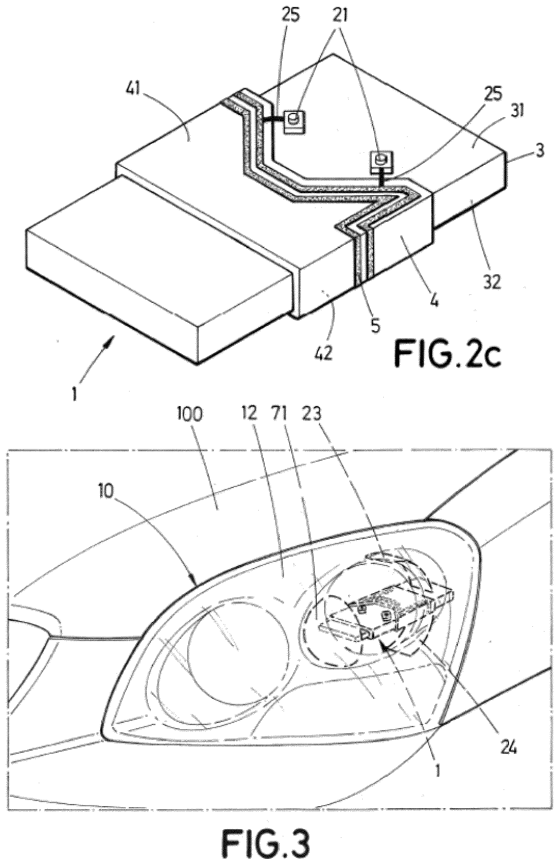

Figure 2c shows the step e of a method according to the invention. The light sources 21, 22 are electrically connected with the conductive track. The light sources comprise an upper semiconductor light source 21, comprising three high power LED devices and a lower semiconductor light source 22, comprising two high power LED devices. This electric connection is achieved by means of conductive wires 25.

Figure 3 shows a lighting device 10 according to the invention, comprising
an electronic assembly 1 as shown in figure 2a
a projection lens 71; and
a housing 12 accommodating the electronic assembly 1 and the projection lens 71.

This lighting device 10 is installed in an automotive vehicle 100 and able to perform lighting functions, such as high-beam and low-beam.

In the particular embodiment shown in this figure, the optical elements include the reflectors 23, 24 and a projection lens 71. The projection lens 71 orientates this received light according to the vehicle advancing direction.

This electronic assembly 1 saves space and weight, because its manufacturing requires less time and a lower number of elements.

## Claims

1. An automotive electronic assembly (1) comprising
a light source (21, 22);
a heat sink (3) in thermal contact with the light source (21, 22);
a plastics substrate (4) at least partially coating the heat sink (3);
a conductive track (5) directly deposited on the plastics substrate (4), the conductive track (5) being electrically connected to the light source (21, 22).

2. An automotive electronic assembly (1) wherein the plastics substrate is a three-dimensional plastics substrate.

3. An automotive electronic assembly (1) according claim 2, wherein the three-dimensional plastics substrate (4) is arranged in such a way that a first region (41) of the three-dimensional plastics substrate (4) extends on a first face (31) of the heat sink (3) and a second region (42) of the three-dimensional plastics substrate (4) extends on a second face (32) of the heat sink (3) opposite to the first face (31).

4. An automotive electronic assembly (1) according to claim 3, comprising a plurality of light sources (21, 22), at least an upper light source (21) being located on the first region (41) and at least a lower light source (22) being located on the second region (42).

5. An automotive electronic assembly (1) according to any of the preceding claims, wherein the plastics substrate (4) is made of at least one of the following materials: acrylonitrile butadiene styrene (ABS), polycarbonate (PC), a blend of ABS and PC, polybutylene terephthalate or polyamide.

6. An automotive electronic assembly (1) according to any of the preceding claims, the conductive track (5) being deposited by plasma deposition.

7. An automotive electronic assembly (1) according to any of the preceding claims, the light source (21, 22) being a semiconductor light source.

8. An automotive electronic assembly (1) according to any of the preceding claims, wherein the heat sink (3) is made of aluminium, an aluminium alloy or a thermal conductive plastic.

9. An automotive electronic assembly (1) according to any of the preceding claims, wherein the electric connection between the light source (21, 22) and the conductive track (5) is made by means of at least one conductive metal wire or ribbon (25) which is attached both to one of the semiconductor light sources (21, 22) and to the conductive track (5).

10. An automotive electronic assembly (1) according to claim 9, further comprising
an upper reflector (23) arranged to reflect the light emitted by the at least one upper light source (21); and
a lower reflector (24) arranged to reflect the light emitted by the at least one lower light source (22).

11. An automotive electronic assembly (1) according to claim 10, further comprising a folder (6) configured to block at least part of the light reflected by the upper reflector (24) in order to form a low-beam light pattern.

12. A method for manufacturing an automotive electronic assembly (1) according to any of preceding claims, the method comprising the steps of
providing a light source (21, 22);
providing a heat sink (3) in thermal contact with the light source (21, 22);
coating the heat sink (3) with a three-dimensional plastics substrate (4);
depositing a conductive track (5) directly on the plastics substrate (4); and
provide an electric connection between the light source (21, 22) and the conductive track (5).

13. A method according to claim 12, wherein the step of depositing a conductive track (5) directly on the plastics substrate (4) is carried out by plasma deposition.

14. A method according to any one of claims 12 or 13, wherein the step of coating the heat sink (3) with a three-dimensional plastics substrate (4) is carried out in such a way that a first region (41) of the three-dimensional plastics substrate (4) is extended on a first face (31) of the heat sink (3) and a second region (42) of the three-dimensional plastics substrate (4) is extended on a second face (32) of the heat sink (3) opposite to the first face (31).

15. A method according to any ones of claims from 12 to 14, wherein the step of coating the heat sink (3) with a three-dimensional plastics substrate (4) is carried out by overmoulding the plastics substrate (4) directly over the heat sink (3).
